# EUROPEAN PATENT APPLICATION

(11) **EP 4 734 112 A1**
(43) Date of publication of application: **29.04.2026**
(21) Application number: 25189866.4
(22) Date of filing: 16.07.2025
(51) Int. Cl.: G11C 5/02, G11C 5/14, G11C 7/22, G11C 7/24

(54) **SEMICONDUCTOR DEVICE**

(30) Priority: 25.10.2024 KR 20240147390
(71) Applicant: SAMSUNG ELECTRONICS CO., LTD., Yeongtong-gu Suwon-si, Gyeonggi-do 16677 (KR)
(72) Inventor: YOO, Hyunjoon, 16677 Suwon-si, Gyeonggi-do (KR); MOON, Youngsik, 16677 Suwon-si, Gyeonggi-do (KR); LEE, Jinwook, 16677 Suwon-si, Gyeonggi-do (KR); JEONG, Yongtaek, 16677 Suwon-si, Gyeonggi-do (KR)
(74) Representative: Kuhnen & Wacker Patent- und Rechtsanwaltsbüro PartG mbB

(57) **Abstract**

A memory device includes: a first memory die (51) including a first monitoring pad connected to a monitoring line (ML1), and a first current monitoring logic configured to output a first current monitoring signal to the first monitoring pad; and a second memory die (52) including a second monitoring pad connected to the monitoring line (ML1), and a second current monitoring logic configured to output a second current monitoring signal to the second monitoring pad, wherein the first current monitoring signal includes first current data of N bits, the first current data including a peak value of a consumption current of the first memory die (51), N being a natural number equal to or greater than two, wherein the second current monitoring signal includes second current data of N bits, the second current data including a peak value of a consumption current of the second memory die (52), wherein the first current monitoring logic and the second current monitoring logic are configured to alternately occupy the monitoring line (ML1), and wherein the first current monitoring logic is configured to recover a first clock signal using the second current monitoring signal that is output to the monitoring line (ML1), and the second current monitoring logic is configured to recover a second clock signal using the first current monitoring signal that is output to the monitoring line (ML1).

## Description

### BACKGROUND

A memory device may provide a function of storing and erasing data, or reading stored data and transmitting the same externally. The memory device may include a plurality of memory dies packaged as one, and some of the memory dies included in the memory device may share a channel for communicating with an external memory controller or the like. When an amount of current consumption increases excessively in one of the memory dies sharing the channel, an amount of power consumption of the memory device may exceed an effective power range that a power circuit supplying power voltage to the memory device can supply. Accordingly, performance of a memory device and/or performance of a system including the memory device may be degraded, and unintended malfunctions, data loss, or the like may occur.

### SUMMARY

An aspect of the present disclosure is to provide a memory device that may suppress a problem situation that may occur when power consumption of the memory device exceeds an effective power range by respectively allowing memory dies sharing a channel to share a peak value of current consumption.

According to an aspect of the present disclosure, a memory device includes a first memory die including a first monitoring pad connected to a monitoring line, and a first current monitoring logic outputting a first current monitoring signal to the first monitoring pad; and a second memory die including a second monitoring pad connected to the monitoring line, and a second current monitoring logic outputting a second current monitoring signal to the second monitoring pad, wherein the first current monitoring signal includes first current data of N bits (where N is a natural number equal to or greater than 2) encoding a peak value of a consumption current of the first memory die, and the second current monitoring signal includes second current data of N bits encoding a peak value of a consumption current of the second memory die, the first current monitoring logic and the second current monitoring logic alternately occupy the monitoring line, and the first current monitoring logic recovers a first clock signal using the second current monitoring signal output to the monitoring line, and the second current monitoring logic recovers a second clock signal using the first current monitoring signal output to the monitoring line.

According to an aspect of the present disclosure, a memory device includes a package substrate; and a plurality of memory dies mounted on the package substrate and configured to share a channel, wherein each of the plurality of memory dies includes a monitoring pad electrically isolated from the channel, wherein the monitoring pad is connected to a monitoring line, and the plurality of memory dies output a current monitoring signal including current data encoding a peak value of a consumption current to the monitoring line, while alternately occupying the monitoring line.

According to an aspect of the present disclosure, a memory device includes a plurality of memory dies configured to share a channel, wherein each of the plurality of memory dies includes a monitoring pad, and the monitoring pad is connected to a monitoring line, wherein the plurality of memory dies alternately occupy the monitoring line and output a current monitoring signal including a peak value of a consumption current to the monitoring line, wherein the current monitoring signal output by one memory die, among the plurality of memory dies, to the monitoring line is transmitted to remaining memory dies among the plurality of memory dies, and wherein each of the remaining memory dies stops a control operation when the peak value of the consumption current of the one memory die is equal to or greater than a predetermined reference value.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a view illustrating a memory device according to an implementation.
FIGS. 2 and 3 are block diagrams illustrating a system including a memory device according to an implementation.
FIGS. 4 and 5 are views illustrating operations of memory dies included in a memory device according to an implementation.
FIG. 6 is a block diagram illustrating a memory device according to an implementation.
FIGS. 7 to 9 are views illustrating an operation of a memory device according to an implementation.
FIGS. 10 to 12 are views illustrating an operation of a memory device according to an implementation.
FIG. 13 is a view illustrating an operation of a memory device according to an implementation.
FIG. 14 is a view illustrating an operation of a memory device according to an implementation.
FIGS. 15 and 16 are views illustrating an operation of a memory device according to an implementation.
FIGS. 17 and 18 are views illustrating an operation of a memory device according to an implementation.

### DETAILED DESCRIPTION

Hereinafter, preferred implementations will be described with reference to the attached drawings as follows.

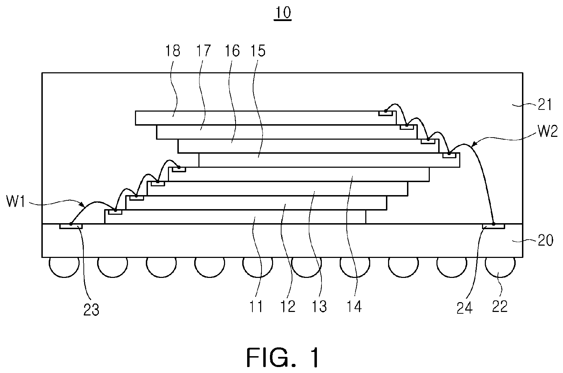

FIG. 1 is a view illustrating a memory device according to an implementation.

Referring to FIG. 1, a memory device 10 according to an implementation may include a plurality of memory dies 11 to 18 and a package substrate 20. The plurality of memory dies 11 to 18 may be mounted in a stack structure on an upper surface of the package substrate 20, and a plurality of solder balls 22 may be formed on a lower surface of the package substrate 20. A protective layer 21 covering the plurality of memory dies 11 to 18 may be formed on the upper surface of the package substrate 20.

In an implementation illustrated in FIG. 1, the plurality of memory dies 11 to 18 may be stacked to form a step shape in one direction. First to fourth memory dies 11 to 14 may be stacked to form a step shape in a first direction, and fifth to eighth memory dies 15 to 18 may be stacked to form a step shape in a direction, opposite to the first direction. The first to fourth memory dies 11 to 14 may be connected to pads 23 exposed on the upper surface of the package substrate 20 by a first wire W1, and the fifth to eighth memory dies 15 to 18 may be connected to pads 24 exposed on the upper surface of the package substrate 20 by a second wire W2.

The stack structure of the plurality of memory dies 11 to 18 is not limited to the configuration as illustrated in FIG. 1. For example, the plurality of memory dies 11 to 18 may be stacked in a vertical direction, and may be electrically connected to the package substrate 20 by through-silicon via structures penetrating at least a portion of the plurality of memory dies 11 to 18. In a structure of the above-described implementation, the memory device 10 may not include the wires W1 and W2.

In an implementation illustrated in FIG. 1, the first to fourth memory dies 11 to 14 may share a first channel, and the fifth to eighth memory dies 15 to 18 may share a second channel. The first and second channels may include signal paths for transmitting a command signal, an address signal, a data signal, a chip enable signal, a write/read enable signal, or the like, respectively.

The first to fourth memory dies 11 to 14 sharing the first channel may monitor each other's peak values of consumption current through a monitoring line. In addition, the fifth to eighth memory dies 15 to 18 sharing the second channel may also monitor each other's peak values of consumption current through a monitoring line. The monitoring lines may be electrically separated from the first channel and the second channel, and may also be electrically separated from the solder balls 22 formed on the lower surface of the package substrate 20.

For example, the first to fourth memory dies 11 to 14 may alternately and sequentially output peak values of consumption current through a monitoring line. When the first memory die 11 outputs a peak value of consumption current, the second to fourth memory dies 12 to 14 may control whether to execute a control operation, timing of execution of the control operation, or the like, while monitoring the peak value of consumption current of the first memory die 11.

For example, when an operation of consuming a large amount of current is performed in each of two or more of the first to fourth memory dies 11 to 14, power consumption of the memory device 10 may exceed an effective range of power that a power circuit may supply to the memory device 10. In this case, a phenomenon, such as performance of the memory device 10 and/or performance of a system including the memory device 10 deteriorates, an operation is temporarily suspended, or the like, may occur.

In an implementation, such a phenomenon may be effectively suppressed by each of the memory dies 11 to 18 sharing one channel monitoring the peak value of the current consumption with each other. For example, when a control operation of consuming a relatively large amount of current, such as a program operation or an erase operation, may be performed in the first memory die 11, the second to fourth memory dies 12 to 14 may temporarily suspend the control operation and then resume the same again with reference to the peak value of the current consumption of the first memory die 11, respectively. Therefore, the power consumption of the memory device 10 may be managed such that the power circuit does not exceed the effective range of power that may be supplied to the memory device 10.

In an implementation, the memory dies 11 to 18 sharing the channel may monitor the peak value of the current consumption with each other through a monitoring line without a separate clock signal. Therefore, the separate clock line for monitoring and sharing the peak value of the current consumption with each other may not be required, and each of the memory dies 11 to 18 may monitor current consumption of other memory dies of the memory dies 11 to 18 simply by adding one pad connected to the monitoring line to each of the memory dies 11 to 18.

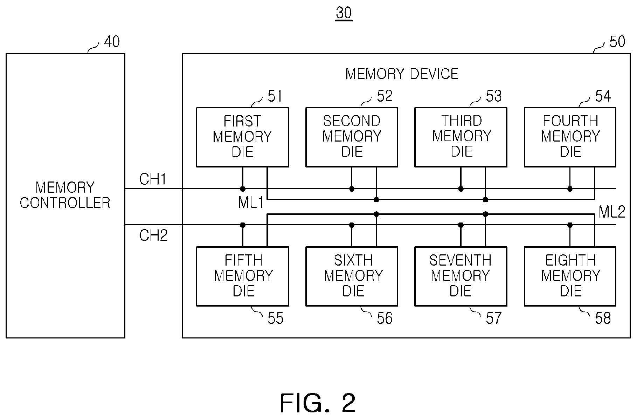

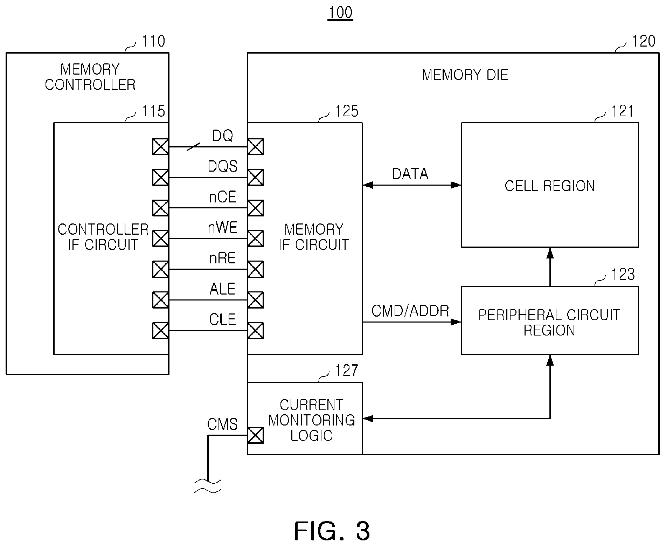

FIGS. 2 and 3 are block diagrams illustrating a system including a memory device according to an implementation.

First, referring to FIG. 2, a system 30 according to an implementation may include a memory controller 40 and a memory device 50. The memory device 50 may include a plurality of memory dies 51 to 58, and the memory controller 40 may be connected to the plurality of memory dies 51 to 58 through a plurality of channels CH1 and CH2. In an implementation illustrated in FIG. 2, the memory controller 40 may be connected to first to fourth memory dies 51 to 54 through a first channel CH1, and may be connected to fifth to eighth memory dies 55 to 58 through a second channel CH2.

The first channel CH1 and the second channel CH2 may include a plurality of signal paths through which a signal is transmitted, respectively. For example, the first channel CH1 and the second channel CH2 may include a plurality of signal paths for transmitting a chip enable signal, a write/read enable signal, a data signal, a data strobe signal, a command signal, an address signal, or the like, respectively.

In an implementation, each of the plurality of memory dies 51 to 58 may include a current monitoring logic monitoring consumption current of other memory dies 51 to 58. For example, the first to fourth memory dies 51 to 54 sharing the first channel CH1 may be commonly connected to one monitoring line, respectively, and may sequentially output peak values of consumption current alternately through the monitoring line, respectively. For example, the peak values of consumption current output by each of the first to fourth memory dies 51 to 54 to the monitoring line may be monitored by the other memory dies 51 to 54. For example, the first to third memory dies 51 to 53 may monitor the peak values of consumption current output by the fourth memory die 54 to the monitoring line.

Each of the memory dies 51 to 58 may stop and/or postpone execution of a control operation with reference to the results of monitoring the peak values of consumption current. For example, when the peak value of the consumption current output by the fourth memory die 54 to the monitoring line may be greater than a predetermined reference value, each of the first to third memory dies 51 to 53 may stop and/or postpone execution of the control operation. Therefore, the total power consumption of the memory device 50 may be controlled within a range not exceeding a maximum value of allowable power consumption.

Referring to FIG. 3, a system 100 according to an implementation may include a memory controller 110 and a memory die 120. The memory die 120 may be one of the plurality of memory dies 51 to 58 included in the memory device 50 described above with reference to FIG. 2. The memory die 120 may include a cell region 121, a peripheral circuit region 123, a memory interface circuit 125, a current monitoring logic 127, and the like. The memory interface circuit 125 may be connected to a controller interface circuit 115 of the memory controller 110.

The memory interface circuit 125 may receive a chip enable signal nCE, a write enable signal nWE, a read enable signal nRE, a command latch enable signal CLE, an address latch enable signal ALE, and a data strobe signal DQS, from the controller interface circuit 115 through a plurality of pads. The peripheral circuit region 123 of the memory die 120 may control the cell region 121 in response to a command/address signal CMD/ADDR included in a signal received from the memory controller 110. For example, the peripheral circuit region 123 may store data DATA received as a data signal DQ in the cell region 121 or read data DATA stored in the cell region 121.

The current monitoring logic 127 of the memory die 120 may detect and output a peak value of current consumed by the memory die 120. For example, the current monitoring logic 127 may output a current monitoring signal CMS including a peak value of current consumption determined according to a control operation executed by the peripheral circuit region 123 to a monitoring line. For example, the current monitoring logic 127 may encode the peak value of the current consumption into current data of N bits (where N is a natural number equal to or greater than 2), and may output a current monitoring signal CMS including the current data to the monitoring line.

Using the current monitoring signal CMS output by the memory die 120, a peak value of current consumed by other memory dies may be monitored in the memory die 120. In the same manner, the memory die 120 may monitor the peak value of the current consumed by each of the other memory dies based on a current monitoring signal CMS output by each of the other memory dies.

For example, in a program operation, an erase operation, or the like of the memory die 120, the peripheral circuit region 123 may apply a relatively large amount of voltage to the cell region 121, and current consumption of the memory die 120 may increase. Therefore, when the program operation, the erase operation, and the like are simultaneously performed in memory dies connected to the same channel as the memory controller 110, power consumption of a memory device including the memory die 120 may exceed an allowable range. When a peak value of current consumed by another memory die is equal to or exceeds a predetermined reference value, the memory die 120 may temporarily suspend or postpone a control operation performed by the peripheral circuit region 123, thereby managing the power consumption of the memory device such that it does not exceed the allowable range.

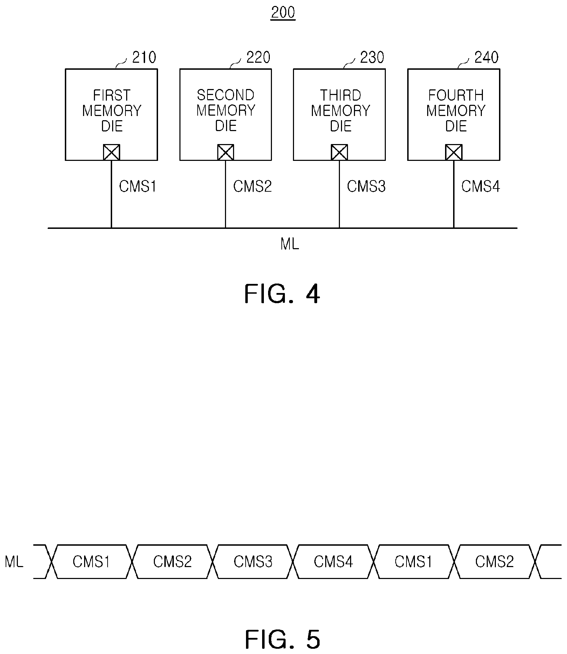

FIGS. 4 and 5 are views illustrating operations of memory dies included in a memory device according to an implementation.

First, referring to FIG. 4, a memory device 200 according to an implementation may include a plurality of memory dies 210 to 240. In an implementation illustrated in FIG. 4, the plurality of memory dies 210 to 240 may be connected to a memory controller through a channel, and may be commonly connected to a monitoring line ML.

The plurality of memory dies 210 to 240 may sequentially occupy the monitoring line ML, and may output current data CD1 to CD4 to the monitoring line ML. Referring to FIG. 5, current monitoring signals CMS1 to CMS4 of each of the plurality of memory dies 210 to 240 may be sequentially output to the monitoring line ML alternately.

For example, a first memory die 210 may output a first current monitoring signal CMS 1 while occupying the monitoring line ML for a first time period, and a second memory die 220 may output a second current monitoring signal CMS2 while occupying the monitoring line ML for a second time period after the first time period. A third memory die 230 may output a third current monitoring signal CMS3 while occupying the monitoring line ML for a third time period after the second time period, and a fourth memory die 240 may output a fourth current monitoring signal CMS4 while occupying the monitoring line ML for a fourth time period after the third time period.

The plurality of memory dies 210 to 240 may output the current monitoring signals CMS1 to CMS4 to the monitoring line ML, respectively, while changing a transmission/reception mode. For example, the first memory die 210 may operate in the transmission mode, and may output the first current monitoring signal CMS1 to the monitoring line ML. After a last bit of the first current monitoring signal CMS1 is output to the monitoring line ML and before a first bit of the second current monitoring signal CMS2 is output to the monitoring line ML, the first memory die 210 may switch from the transmission mode to the reception mode, and the second memory die 220 may switch from the reception mode to the transmission mode.

During the first time period, the second to fourth memory dies 220 to 240 may receive the first current monitoring signal CMS1, and during the second time period, the first, third, and fourth memory dies 210, 230, and 240 may receive the second current monitoring signal CMS2. During the third time period, the first, second, and fourth memory dies 210, 220, and 240 may receive the third current monitoring signal CMS3, and during the fourth time period, the first to third memory dies 210 to 230 may receive the fourth current monitoring signal CMS4.

The second to fourth memory dies 220 to 240 may detect a first peak value of current consumed by the first memory die 210 with reference to the first current monitoring signal CMS1, and when the first peak value is equal to or greater than a predetermined reference value, execution of a control operation may be temporarily suspended. The first, third and fourth memory dies 210, 230, and 240 may detect a second peak value of current consumed by the second memory die 220 with reference to the second current monitoring signal CMS2, and when the second peak value is equal to or greater than the predetermined reference value, the execution of the control operation may be temporarily suspended.

The first, second, and fourth memory dies 210, 220, and 240 may detect a third peak value of current consumed by the third memory die 230 with reference to the third current monitoring signal CMS3, and when the third peak value is equal to or greater than the predetermined reference value, the execution of the control operation may be temporarily suspended. The first to third memory dies 210 to 230 may detect a fourth peak value of current consumed by the fourth memory die 240 with reference to the fourth current monitoring signal CMS4, and when the fourth peak value is equal to or greater than the predetermined reference value, the execution of the control operation may be temporarily suspended.

According to an implementation, each of the plurality of memory dies 210 to 240 may temporarily suspend the execution of the control operation when a sum of peak values of current is equal to or greater than a reference value. For example, each of the first to third memory dies 210 to 230 may detect the fourth peak value of the current consumed by the fourth memory die 240 with reference to the fourth current monitoring signal CMS4. Each of the first to third memory dies 210 to 230 may temporarily suspend the execution of the control operation when a sum of internally calculated peak values of the current consumed plus the fourth peak value is equal to or greater than the reference value.

In the above manner, each of the plurality of memory dies 210 to 240 may adjust execution time of the control operation with reference to the peak value of the current consumed by the other memory dies. Therefore, the power consumption of the memory device 200 is limited not to exceed an allowable range specified in a predetermined specification, and operational stability of the memory device 200 may be improved and power consumption may be reduced.

As illustrated in FIG. 4, in an implementation, the plurality of memory dies 210 to 240 may output only the current monitoring signals CMS1 to CMS4 to the monitoring line ML without a separate clock signal. Therefore, in implementing a current monitoring function between the plurality of memory dies 210 to 240 sharing a channel, only one monitoring pad may be added to each of the plurality of memory dies 210 to 240.

For example, each of the plurality of memory dies 210 to 240 may include a clock recovery circuit recovering the clock signal from the current monitoring signals CMS1 to CMS4 output to the monitoring line ML. Each of the plurality of memory dies 210 to 240 may obtain the peak value of the consumption current included in the current monitoring signals CMS1 to CMS4 using the recovered clock signal.

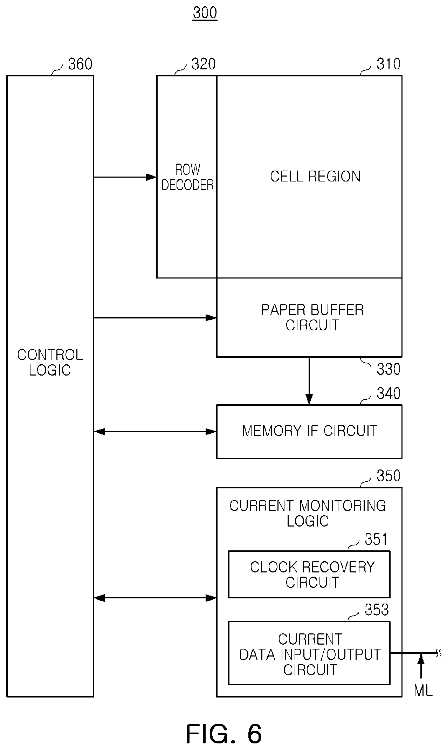

FIG. 6 is a block diagram simply illustrating a memory device according to an implementation.

Referring to FIG. 6, a memory die 300 according to an implementation may include a cell region 310, a row decoder 320, a page buffer circuit 330, a memory interface circuit 340, a current monitoring logic 350, a control logic 360, and the like. The cell region 310 may include memory cells disposed in a cell array form. The memory cells may be connected to the row decoder 320 through word lines, common source lines, ground select lines, and string select lines, and may be connected to the page buffer circuit 330 through bit lines.

The memory interface circuit 340 may transmit data read from memory cells by the page buffer circuit 330 externally, or may transfer data received from the outside to the page buffer circuit 330. The current monitoring logic 350 may monitor a peak value of current consumed by another memory die by using current data output by another memory die sharing the same channel as the memory die 300. The row decoder 320, the page buffer circuit 330, the memory interface circuit 340, and the current monitoring logic 350 may be controlled by the control logic 360.

In an implementation, the current monitoring logic 350 may include a clock recovery circuit 351, a current data input/output circuit 353, and the like. The current data input/output circuit 353 may output a current monitoring signal to a monitoring line ML or receive the current monitoring signal from the monitoring line ML. The clock recovery circuit 351 may recover a clock signal using the current monitoring signal received from the monitoring line ML.

Therefore, the memory die 300 and other memory dies sharing the same channel as the memory die 300 may send and receive current monitoring signals to the monitoring line ML without a separate clock signal. It may be sufficient to add only one monitoring pad to the memory die 300 to share a peak value of consumed current, and an increase in area of the memory die 300 may be minimized.

The current monitoring logic 350 may output a current monitoring signal including a peak value of current consumed by the memory die 300 to the outside, in response to control of the control logic 360. The current monitoring logic 350 may receive a current monitoring signal of another memory die, and may transmit a received current monitoring signal to the control logic 360. When a peak value of current consumed by another memory die exceeds a reference value, the control logic 360 may temporarily suspend a control operation performed by the row decoder 320 and the page buffer circuit 330 on the memory cells. Therefore, it is possible to control power consumption of a memory device including memory dies sharing the same channel with the memory die 300 not to exceed an allowable range, and to secure a stable operation of the memory device and a system including the memory device.

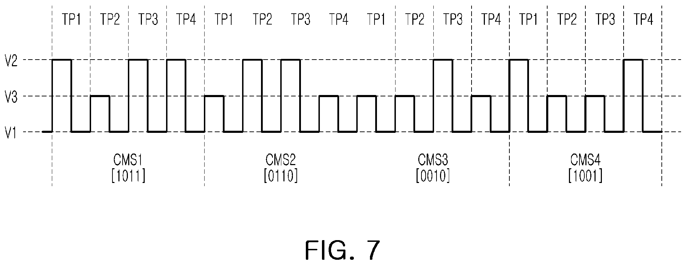

FIGS. 7 to 9 are views illustrating an operation of a memory device according to an implementation.

FIG. 7 may be a view illustrating current monitoring signals CMS1 to CMS4 output by memory dies included in a memory device and sharing the same channel. As described above with reference to other implementations, memory dies sharing a channel may be commonly connected to a monitoring line, and may alternately output current monitoring signals CMS 1 to CMS4 to the monitoring line.

In an implementation illustrated in FIG. 7, first to fourth memory dies included in a memory device may be commonly connected to a monitoring line. The first memory die may output a first current monitoring signal CMS1, the second memory die may output a second current monitoring signal CMS2, the third memory die may output a third current monitoring signal CMS3, and the fourth memory die may output a fourth current monitoring signal CMS4. Therefore, as illustrated in FIG. 7, the first to fourth current monitoring signals CMS1 to CMS4 may be output in sequence in an alternating manner.

The first to fourth current monitoring signals CMS1 to CMS4 may be a return-to-zero (RZ) signal. Referring to FIG. 7, the first to fourth current monitoring signals CMS1 to CMS4 may return to a first voltage V1, which may be a reference voltage, every cycle (TP1 to TP4).

Each of the first to fourth memory dies may encode a peak value of a consumption current into N-bit current data. Each of the first to fourth memory dies may occupy the monitoring line for a time period corresponding to N cycles (TP1 to TP4), and may output 1 bit of the N-bit current data in each of the N cycles (TP1 to TP4). In an implementation illustrated in FIG. 7, each of the first to fourth memory dies may output 4-bit current data to the monitoring line, 1 bit per cycle, for four cycles (TP1 to TP4). The number of bits of the current data may be changed depending on an implementation.

A minimum voltage of the current monitoring signals CMS1 to CMS4 may be the first voltage V1, and a maximum voltage may be a second voltage V2. The current monitoring signals CMS1 to CMS4 may swing between the first voltage V1 and the second voltage V2, or between the first voltage V1 and a third voltage V3, in each of the four cycles (TP1 to TP4) that output 4-bit current data to the monitoring line. The third voltage V3 may be an intermediate voltage, less than the second voltage V2 and greater than the first voltage V1.

In an implementation illustrated in FIG. 7, the current monitoring logic of the memory die may output data of logic '1' by outputting the current monitoring signals CMS1 to CMS4 that swing between the first voltage V1 and the second voltage V2 during one cycle. In addition, the current monitoring logic may output data of logic '0' by outputting the current monitoring signals CMS1 to CMS4 that swing between the first voltage V1 and the third voltage V3 during one cycle.

For example, the first current monitoring signal CMS1 may swing between the first voltage V1 and the second voltage V2 during each of a first cycle TP1, a third cycle TP3, and a fourth cycle TP4 among the four cycles (TP1 to TP4), and may swing between the first voltage V1 and the third voltage V3 during a second cycle TP2. A first current monitoring logic included in the first memory die may output first current data of [1011], which encodes a peak value of current consumed by the first memory die, as the first current monitoring signal CMS1.

Similarly, a second current monitoring logic of the second memory die may output second current data of [0110], which encodes a peak value of current consumed by the second memory die, as the second current monitoring signal CMS2, and a third current monitoring logic of the third memory die may output third current data of [0010], which encodes a peak value of current consumed by the third memory die, as the third current monitoring signal CMS3. A fourth current monitoring logic of the fourth memory die may output fourth current data of [1001], which encodes a peak value of current consumed by the fourth memory die, as the fourth current monitoring signal CMS4. As illustrated in FIG. 7, it can be understood that during a time period when the first to fourth memory dies output the current monitoring signals CMS1 to CMS4, the peak values of the current consumption in the first memory die and the fourth memory die may be relatively large.

Each of the first to fourth memory dies may monitor peak values of current consumed by other memory dies with reference to the current monitoring signals CMS1 to CMS4 and, based thereon, determine whether to execute/stop a control operation. For example, assuming that the first current data included in the first current monitoring signal CMS1 output by the first memory die may be greater than a predetermined reference value, each of the second to fourth memory dies may temporarily stop executing the control operation such as a program operation, an erase operation, a read operation, or the like. Therefore, while the first memory die consumes a large amount of current, current consumption of the other second to fourth memory dies may be reduced, and power consumption of the memory device including the first to fourth memory dies may be limited to an acceptable range.

In an implementation illustrated in FIG. 7, both logic '1' and logic '0' may be expressed as voltage levels greater than the first voltage V1. The current monitoring logic included in each of the first to fourth memory dies may recover a clock signal from the current monitoring signal CMS1 to CMS4 received through the monitoring line, and may decode current data encoded as the current monitoring signal CMS1 to CMS4 using a recovered clock signal.

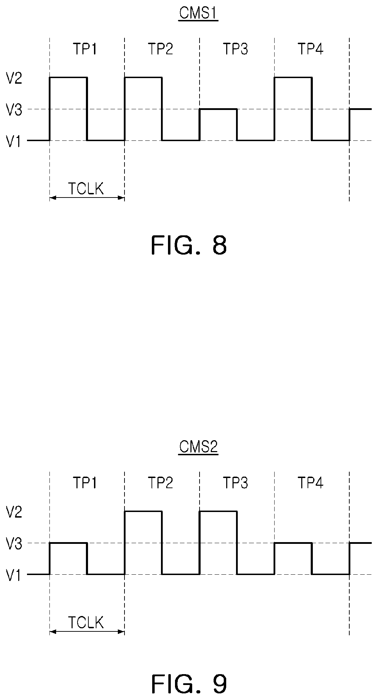

FIG. 8 may be an enlarged view of a first current monitoring signal CMS1, and FIG. 9 may be an enlarged view of a second current monitoring signal CMS2. In an implementation illustrated in FIG. 8, while a first current monitoring logic of a first memory die occupies a monitoring line and outputs a first current monitoring signal CMS1, a current monitoring logic of each of second to fourth memory dies may receive the first current monitoring signal CMS1.

The current monitoring logic of each of the second to fourth memory dies may determine a clock cycle TCLK required to recover a clock signal by counting a time period between a first rising edge of the first current monitoring signal CMS1 corresponding to a time point of a first cycle TP1 and a second rising edge of the first current monitoring signal CMS1 corresponding to a time point of a second cycle TP2. The current monitoring logic of each of the second to fourth memory dies may generate a clock signal having the clock cycle TCLK, and may decode the first current data of [1011] by comparing the first current monitoring signal CMS1 with a predetermined reference voltage at each time point synchronized with the clock signal. For example, the reference voltage compared with the first current monitoring signal CMS1 at a rising edge and/or a falling edge of the clock signal to decode first current data may be less than a second voltage V2 and greater than a third voltage V3.

In an implementation illustrated in FIG. 9, while a second current monitoring logic of a second memory die occupies a monitoring line and outputs a second current monitoring signal CMS2, a current monitoring logic of each of first, third, and fourth memory dies may receive the second current monitoring signal CMS2.

The current monitoring logic of each of the first, third and fourth memory dies may determine a clock cycle TCLK required to recover a clock signal by counting a time period between a first rising edge of the first current monitoring signal CMS1 corresponding to a time point of a first cycle TP1 and a second rising edge of the first current monitoring signal CMS1 corresponding to a time point of a second cycle TP2. Since logic '0' corresponds to a third voltage V3, greater than a first voltage V1, and logic '1' corresponds to a second voltage V2, greater than the first voltage V1, the current monitoring logic may determine the clock cycle TCLK regardless of whether a bit transmitted in each of the first cycle TP1 and the second cycle TP2 is logic '0' or logic '1'. The current monitoring logic of each of the first, third and fourth memory dies may decode second current data of [0110] by comparing a second current monitoring signal (CD2) with a reference voltage in synchronization with a recovered clock signal.

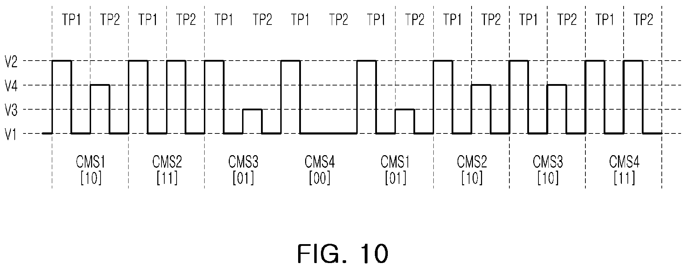

FIGS. 10 to 12 are views illustrating an operation of a memory device according to an implementation.

In an implementation, memory dies may generate and output current monitoring signals CMS1 to CMS4 as a pulse amplitude modulation (PAM)-N signal, respectively. In implementations described with reference to FIGS. 10 to 12, the current monitoring signals CMS1 to CMS4 may be generated as a PAM-4 signal, and depending on an implementation, N of the PAM-N signal may be determined as a value different from 4.

FIG. 10 may be a view illustrating current monitoring signals CMS1 to CMS4 output by memory dies included in a memory device and sharing the same channel. In an implementation illustrated in FIG. 10, first to fourth memory dies included in the memory device may alternately output the current monitoring signals CMS1 to CMS4 to a monitoring line.

Referring to FIG. 10, current monitoring signals CMS1 to CMS4 may swing between a first voltage V1 which may be a minimum voltage and a second voltage V2 which may be a maximum voltage. First to fourth memory dies may output the current monitoring signals CMS1 to CMS4 while occupying a monitoring line for two cycles TP1 and TP2, respectively. In a first cycle TP1 of the two cycles TP1 and TP2, a reference signal may be output, and in a second cycle TP2, a valid signal representing current data may be output.

The reference signal may be a signal not including current data generated by each of the first to fourth memory dies, and may be an RZ signal swinging between the first voltage V1 and the second voltage V2 regardless of the current data. The valid signal may be a signal including current data generated by each of the first to fourth memory dies. In an implementation illustrated in FIG. 10, each of the first to fourth memory dies may generate and output the valid signal as a multi-level signal in a pulse amplitude modulation (PAM)-4 manner.

Each of the first to fourth memory dies may output the current monitoring signals CMS 1 to CMS4 corresponding to 2-bit current data in the second cycle TP2 occupying the monitoring line. The current monitoring logic of each of the first to fourth memory dies may encode a peak value of consumed current to generate the 2-bit current data, and may output the current monitoring signals CMS1 to CMS4 that may be a multi-level signal matching the 2-bit current data to one of the first to fourth voltages V1 to V4.

A first current monitoring logic of the first memory die may output first current data of [10], which encodes a peak value of current consumed in the second cycle TP2 of a time period of occupying the monitoring line, as a first current monitoring signal CMS1. A second current monitoring logic of the second memory die may output second current data of [11] as a second current monitoring signal CMS2, and a third current monitoring logic of the third memory die may output third current data of [01] as a third current monitoring signal CMS3. A fourth current monitoring logic of the fourth memory die may output fourth current data of [00] as a fourth current monitoring signal CMS4.

Each of the first to fourth memory dies may monitor a peak value of current consumed by the other memory die with reference to the current monitoring signals CMS1 to CMS4, and may determine whether to execute/stop a control operation based on the current monitoring signals. For example, when one of the first to fourth memory dies outputs a current monitoring signal including current data of [11] to the monitoring line, the other memory dies may stop executing the control operation. In an implementation illustrated in FIG. 10, while the second memory die occupies the monitoring line first, it outputs the second current monitoring signal including the second current data of [11], and the first, third, and fourth memory dies may stop executing the control operation. In addition, since the fourth memory die occupies the monitoring line second and outputs the fourth current monitoring signal including the fourth current data of [11], the first to third memory dies may stop executing the control operation in this case.

In an implementation illustrated in FIG. 10, each of the first to fourth memory dies may include a clock recovery circuit, and the clock recovery circuit may recover a clock signal from the current monitoring signal CMS1 to CMS4. For example, the clock recovery circuit may recover the clock signal using a reference signal swinging between the first voltage V1 and the second voltage V2 during the first cycle TP1.

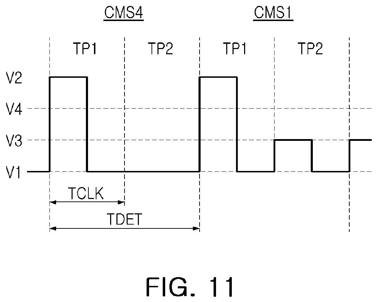

FIG. 11 may be an enlarged graph illustrating the current monitoring signals CMS1 and CMS4 output to the monitoring line during a time period when the fourth memory die occupies the monitoring line in the implementation illustrated in FIG. 10, and subsequently during a time period when the first memory die occupies the monitoring line. A clock cycle TCLK of the clock signal that each of the first to fourth memory dies is to be recovered may be equal to the first cycle TP1.

As illustrated in FIG. 11, when the current data is [00], since a valid signal output in the second cycle TP2 may be maintained as a first voltage, it may be difficult to recover the clock cycle TCLK using only the reference signal of the first cycle TP1, as illustrated in FIG. 11. In this case, the memory die may recover the clock cycle TCLK by counting a time interval TDET between first cycles TP1, which are consecutive.

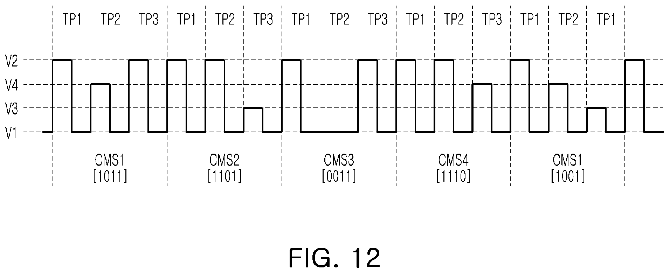

Referring to FIG. 12, current monitoring signals CMS1 to CMS4 may swing between a first voltage V1 which may be a minimum voltage and a second voltage V2 which may be a maximum voltage. First to fourth memory dies may output the current monitoring signals CMS1 to CMS4 while occupying a monitoring line for three cycles TP1 to TP3, respectively, and may output the current monitoring signals CMS1 to CMS4, respectively. In a first cycle TP1 of the three cycles TP1 to TP3 in which the current monitoring signals CMS1 to CMS4 are output, a reference signal may be output, and in a second cycle TP2 and a third cycle TP3, a valid signal representing current data may be output. For example, the reference signal and the valid signal may have a duty ratio of 50%, respectively.

The reference signal does not include current data generated by each of the first to fourth memory dies, and may be a signal swinging between the first voltage V1 and the second voltage V2 regardless of the current data. The valid signal may include the current data generated by each of the first to fourth memory dies.

Each of the first to fourth memory dies may output the current monitoring signals CMS 1 to CMS4 corresponding to 4-bit current data as multi-level signals in the second cycle TP2 and the third cycle TP3 that occupy the monitoring line. For example, upper 2 bits of the 4-bit current data may be output in the second cycle TP2 of the current monitoring signals CMS1 to CMS4, and remaining lower 2 bits thereof may be output in the third cycle TP3. According to an implementation, the lower 2 bits of the 4-bit current data may be output in the second cycle TP2 of the current monitoring signals CMS1 to CMS4, and the remaining upper 2 bits may be output in the third cycle TP3.

The first current monitoring signal CMS1 output by a first current monitoring logic of the first memory die may swing between the first voltage V1 and a fourth voltage V4 during the second cycle TP2, and may swing between the first voltage V1 and the second voltage V2 during the third cycle TP3. Therefore, first current data of [1011] may be output as the first current monitoring signal CMS1. The second current monitoring signal CMS2 may swing between the first voltage V1 and the second voltage V2 during the second cycle TP2, and may swing between the first voltage V1 and the third voltage V3 during the third cycle TP3. Therefore, second current data of [1101] may be output as the second current monitoring signal CMS2.

The third current monitoring signal CMS3 may be maintained at the first voltage V1 during the second cycle TP2 and may swing between the first voltage V1 and the second voltage V2 during the third cycle TP3. Therefore, third current data of [0011] may be output as the third current monitoring signal CMS3. The fourth current monitoring signal CMS4 may swing between the first voltage V1 and the second voltage V2 during the second cycle TP2, and may swing between the first voltage V1 and the fourth voltage V4 during the third cycle TP3. Therefore, fourth current data of [1110] may be output as the fourth current monitoring signal CMS4.

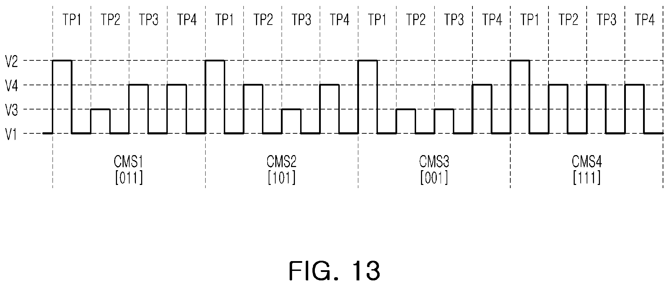

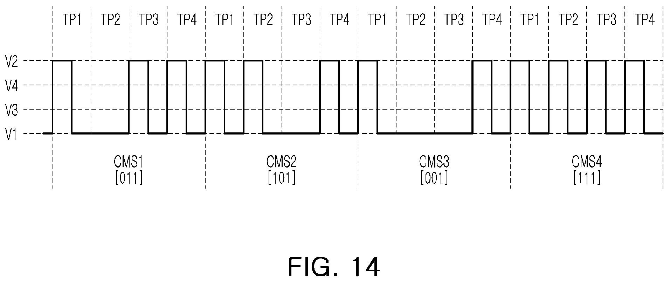

FIGS. 13 and 14 are views illustrating an operation of a memory device according to an implementation.

FIGS. 13 and 14 may be views illustrating current monitoring signals CMS1 to CMS4 output by memory dies included in a memory device and connected to a memory controller through a channel, as a monitoring line, respectively. Each of the memory dies may include a monitoring pad electrically separated from the memory controller, and the monitoring pad may be connected to the monitoring line. The memory dies may alternately occupy the monitoring line in sequence. Each of the memory dies may alternately output the current monitoring signals CMS1 to CMS4 including current data encoding a peak value of consumption current to the monitoring line.

In each of the implementations illustrated in FIGS. 13 and 14, a current monitoring logic of respective first to fourth memory dies may encode a peak value of consumption current into N-bit current data. Each of the first to fourth memory dies may output current monitoring signals CMS1 to CMS4 while occupying a monitoring line for a time period corresponding to N+1 cycles (TP1 to TP4).

Referring to FIG. 13, the current monitoring logic of each of the first to fourth memory dies may output the current monitoring signals CMS1 to CMS4 including 3-bit current data during four cycles (TP1 to TP4). For example, the current monitoring logic may output a reference signal swinging between a first voltage V1 and a second voltage V2 during a first cycle TP1. The reference signal may not be a signal generated from the current data, but may be a signal provided such that the current monitoring logic of each of the other memory dies may recover a clock signal.

The current monitoring logic of each of the first to fourth memory dies may output 1 bit of the 3-bit current data during the second to fourth cycles TP2 to TP4. In an implementation illustrated in FIG. 13, data of logic '0' may be output as a signal swinging between the first voltage V1 and a third voltage V3, and data of logic '1' may be output as a signal swinging between the first voltage V1 and a fourth voltage V4.

In an implementation illustrated in FIG. 13, both logic '0' and logic '1' may be matched with a signal swinging to a voltage level greater than the first voltage V1. The current monitoring logic included in each of the first to fourth memory dies may recover a clock signal from current monitoring signals CMS1 to CMS4 received through the monitoring line, and may extract current data from the current monitoring signal CMS1 to CMS4 using a recovered clock signal. In an implementation, the current monitoring logic may determine a clock cycle of the clock signal by counting a time period from a rising edge of a reference signal output in each first cycle TP1 to a rising edge of a valid signal output in the second cycle TP2.

Referring to FIG. 14, a current monitoring logic of respective first to fourth memory dies may output current monitoring signals CMS1 to CMS4 including 3 bits of current data for four cycles (TP1 to TP4). For example, the current monitoring logic may output a reference signal that swings between a first voltage V1 and a second voltage V2 during a first cycle TP1. The current monitoring logic may output 1 bit of 3-bit current data encoding a peak value of current consumed during the second to fourth cycles TP2 to TP4. In an implementation illustrated in FIG. 14, data of logic '0' may be matched with the first voltage V1, and data of logic '1' may be matched with the second voltage V2.

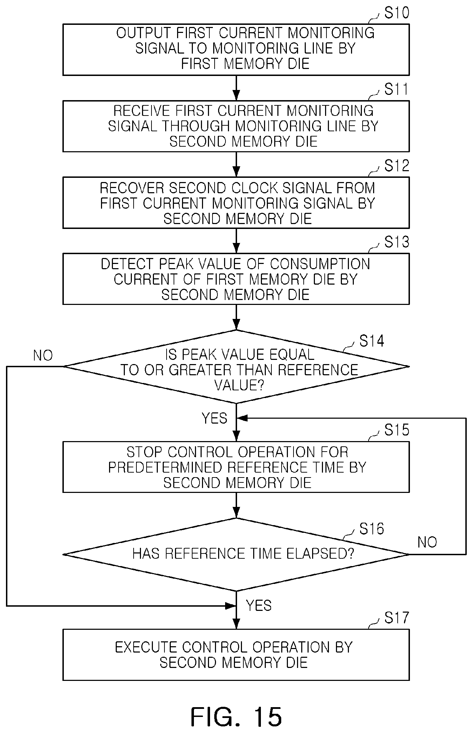

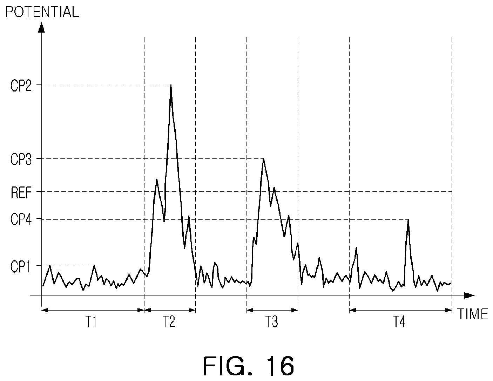

FIGS. 15 and 16 are views illustrating an operation of a memory device according to an implementation.

First, referring to FIG. 15, an operation of a memory device according to an implementation may start with outputting a first current monitoring signal to a monitoring line by a first memory die (S10). The first current monitoring signal may be output by a first current monitoring logic of the first memory die, and the first memory die may include a first monitoring pad connected to the monitoring line. The first current monitoring logic may output the first current monitoring signal while occupying the monitoring line for a predetermined first time period.

A second memory die may receive the first current monitoring signal through the monitoring line (S11). For example, a second current monitoring logic of the second memory die may receive the first current monitoring signal through the monitoring line during the first time period that the first current monitoring logic occupies the monitoring line, and may recover a second clock signal using the first current monitoring signal (S12). The second clock signal may be a clock signal generated by a clock recovery circuit of the second current monitoring logic using the first current monitoring signal, and the second current monitoring logic may detect a peak value of consumption current of the first memory die encoded with the first current monitoring signal using the second clock signal (S13).

The second current monitoring logic may determine whether the peak value of the consumption current of the first memory die detected in S13 may be equal to or greater than a reference value (S14). The reference value applied in S14 may be a value stored at a time of manufacturing the memory die or at a time of manufacturing the memory device packaging the memory dies. Alternatively, according to an implementation, the reference value applied in S14 may be determined by a storage controller, a power management integrated circuit (PMIC), or the like included in a storage device such as a solid state drive (SSD) device or the like, together with the memory die, or a host communicating with the storage device may determine the reference value. When the peak value is equal to or greater than the reference value as a determination result in S14, the second memory die may stop a control operation for a predetermined reference time (S15), wherein the predetermined reference time is a predetermined reference time period. The control operation may be at least one of a program operation, an erase operation, or a read operation.

Thereafter, the second memory die may determine whether the reference time has elapsed (S16), and when it is determined that the reference time has elapsed, the control operation may be executed (S17). When the peak value is less than the reference value as the determination result in S14, the second memory die may execute the control operation (S17).

In an implementation described with reference to FIG. 15, under a condition that the peak value of the consumption current of the first memory die is equal to or greater than the reference value, the second memory die connected to the memory controller through the same channel as the first memory die may stop executing the control operation for the predetermined reference time. This may be a control method that takes into account characteristic that the peak value of the consumption current appears for a very short time. By adding consumption current of the second memory die to the channel during a time period when the consumption current of the first memory die has a peak value, it is possible to prevent a situation in which power consumption of a memory device exceeds an allowable range.

FIG. 16 may be a graph illustrating consumption current of a first memory die over time. In an implementation illustrated in FIG. 16, during a first time period T1, consumption current of a first memory die may have a very small first peak value CP1. Therefore, during the first time period T1, a second memory die sharing a channel with the first memory die may perform a control operation without interruption.

During a second time period T2, the consumption current of the first memory die may increase to a second peak value CP2 higher than a reference value REF. Therefore, the second memory die may temporarily suspend execution of the control operation during the second time period T2 with reference to a first current monitoring signal including current data encoding the second peak value CP2. When the second time period T2 elapses, the second memory die may resume the control operation.

During a third time period T3, the consumption current of the first memory die may also increase to a third peak value CP3 higher than the reference value REF. Therefore, the second memory die may stop executing the control operation during the third time period T3, and may execute the control operation after the third time period T3 has elapsed. During a fourth time period T4, since the consumption current of the first memory die has a fourth peak value CP4 smaller than the reference value REF, the second memory die may execute the control operation without interruption.

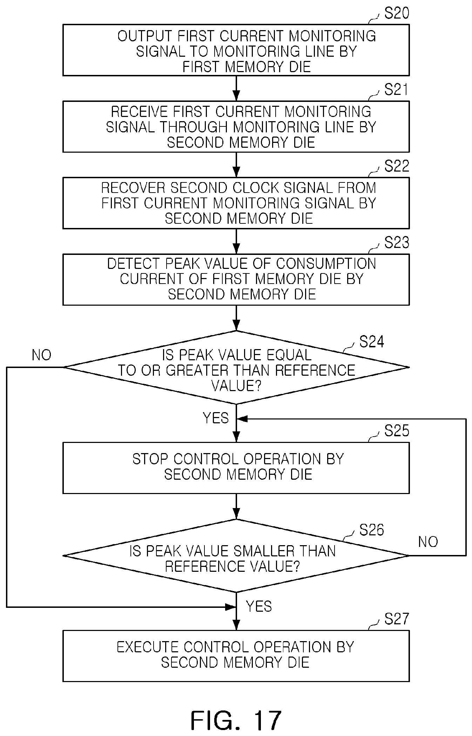

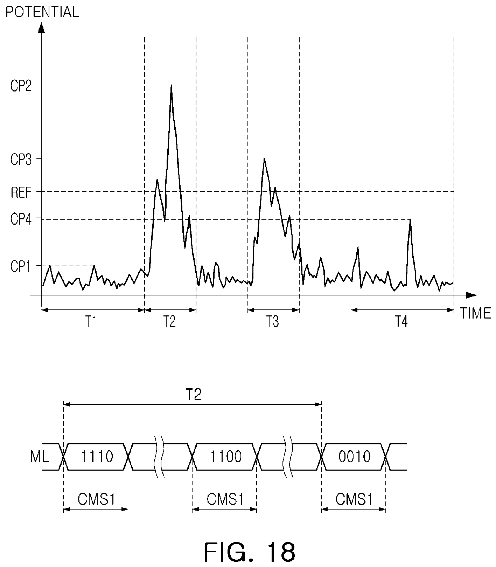

FIGS. 17 and 18 are views illustrating an operation of a memory device according to an implementation.

Referring to FIG. 17, an operation of a memory device according to an implementation may start with outputting a first current monitoring signal to a monitoring line by a first memory die (S20). The first current monitoring signal may be output by a first current monitoring logic of the first memory die, and the first memory die may include a first monitoring pad connected to the monitoring line. The first current monitoring logic may output the first current monitoring signal while occupying the monitoring line for a predetermined first time period.

A second memory die may receive the first current monitoring signal through the monitoring line (S21). For example, a second current monitoring logic of the second memory die may receive the first current monitoring signal through the monitoring line during the first time period that the first current monitoring logic occupies the monitoring line, and may recover a second clock signal using the first current monitoring signal (S22). The second clock signal may be a clock signal generated by a clock recovery circuit of the second current monitoring logic using the first current monitoring signal, and the second current monitoring logic may detect a peak value of consumption current of the first memory die encoded with the first current monitoring signal using the second clock signal (S23).

The second current monitoring logic may determine whether the peak value of the consumption current of the first memory die detected in S23 may be equal to or greater than a reference value (S24). The reference value applied in S24 may be a value stored at a time of manufacturing the memory die or at a time of manufacturing the memory device packaging the memory dies. When the peak value is equal to or greater than the reference value as a determination result in S24, the second memory die may stop a control operation (S25). The control operation may be at least one of a program operation, an erase operation, or a read operation.

After the second memory die stops the control operation, the second current monitoring logic may determine whether the peak value of the consumption current of the first memory die decreases below a reference value by using the first current monitoring signal output to the monitoring line (S26). When it is determined that the peak value of the consumption current of the first memory die extracted from the first current monitoring signal is smaller than the reference value, the second memory die may execute the control operation (S27). When it is determined as the determination result in S26 that the peak value of the consumption current of the first memory die extracted from the first current monitoring signal is greater than the reference value, the second memory die may maintain a state of stopping the control operation.

In an implementation described with reference to FIG. 17, under a condition that the peak value of the consumption current of the first memory die is equal to or greater than the reference value, the second memory die may stop executing the control operation. Thereafter, under a condition that the peak value of the consumption current of the first memory die is confirmed to decrease below the reference value through the monitoring line, the second memory die may re-execute the control operation. Therefore, consumption current of the second memory die may not be added to the channel during a time when the consumption current of the first memory die has a peak value, and it is possible to prevent a situation in which power consumption of a memory device including the first memory die and the second memory die exceeds an allowable range.

FIG. 18 may be a graph illustrating consumption current of a first memory die over time. The graph of FIG. 18 may be equal to the graph illustrated in FIG. 16.

Referring to FIG. 18, a first memory die may output a first current monitoring signal CMS1 to a monitoring line ML at least once during a second time period T2. The second time period T2 may be a time period in which a peak value of consumption current of the first memory die is greater than a reference value REF, and therefore, current data included in the first current monitoring signal CMS1 may be greater than the reference value REF.

When the second time period T2 elapses, the first memory die may output the first current monitoring signal CMS1 including current data smaller than the reference value REF. In an implementation illustrated in FIG. 18, a second memory die may resume a control operation after confirming through the monitoring line ML that the current data included in the first current monitoring signal CMS1 has become smaller than the reference value REF.

According to an implementation, during the second time period T2 when the current data of the first current monitoring signal CMS 1 is greater than the reference value REF, only the first current monitoring signal CMS1 may be repeatedly output through the monitoring line ML. During the second time period T2, the second memory die may not output a current monitoring signal to the monitoring line ML, and the first memory die may repeatedly output the first current monitoring signal CMS1 while occupying the monitoring line ML during the second time period T2. When the current data included in the first current monitoring signal CMS1 is smaller than the reference value REF, the first memory die and the second memory die may alternately occupy the monitoring line ML again.

According to an implementation, memory dies sharing a channel may be commonly connected to a monitoring line, and may sequentially and repeatedly output peak values of consumption current through the monitoring line without a separate clock signal. Each of the memory dies may monitor peak values of consumption current of other memory dies, and may stop or delay execution of a control operation with reference to a peak value of consumption current of at least one of the other memory dies. Therefore, power consumption of a memory device may be controlled within an effective range of power that may be supplied, and performance of the memory device may be improved.

Various advantages and effects of the present disclosure are not limited to the above-described contents, and may be more easily understood in the process of explaining specific implementations.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A memory device comprising:
a first memory die (11, 51, 210) including a first monitoring pad connected to a monitoring line (ML1, ML), and a first current monitoring logic configured to output a first current monitoring signal (CMS1) to the first monitoring pad; and
a second memory die (12, 52, 220) including a second monitoring pad connected to the monitoring line (ML1, ML), and a second current monitoring logic configured to output a second current monitoring signal (CMS2) to the second monitoring pad,
wherein the first current monitoring signal (CMS1) includes first current data of N bits, the first current data including a peak value of a consumption current of the first memory die (11, 51, 210), N being a natural number equal to or greater than two,
wherein the second current monitoring signal (CMS2) includes second current data of N bits, the second current data including a peak value of a consumption current of the second memory die (12, 52, 220),
wherein the first current monitoring logic and the second current monitoring logic are configured to alternately occupy the monitoring line (ML1, ML), and
wherein the first current monitoring logic is configured to recover a first clock signal using the second current monitoring signal (CMS2) that is output to the monitoring line (ML1, ML), and the second current monitoring logic is configured to recover a second clock signal using the first current monitoring signal (CMS1) that is output to the monitoring line (ML1, ML).

2. The memory device of claim 1, wherein, within a cycle, each of the first current monitoring signal (CMS1) and the second current monitoring signal (CMS2) swings (i) between a first voltage (V1) and a second voltage (V2) that is greater than the first voltage (V1), or (ii) between the first voltage (V1) and at least one intermediate voltage (V3, V4), the at least one intermediate voltage (V3, V4) being greater than the first voltage (V1) and less than the second voltage (V2).

3. The memory device of claim 2, wherein the first current monitoring logic and the second current monitoring logic are configured to:
sequentially and repeatedly occupy the monitoring line (ML1, ML) for respective N cycles, and
output the N bits by outputting one bit at a time in a respective cycle of the N cycles.

4. The memory device of claim 2, wherein the first current monitoring logic and the second current monitoring logic are configured to sequentially and repeatedly occupy the monitoring line (ML1, ML) for respective N+1 cycles, and
wherein each of the first current monitoring logic and the second current monitoring logic is configured to output:
a reference signal in a first cycle of the N+1 cycles, and
a valid signal representing the N bits, each bit of the N bits being in a respective cycle of remaining N cycles of the N+1 cycles.

5. The memory device of claim 4, wherein the at least one intermediate voltage (V3, V4) includes a third voltage (V3) and a fourth voltage (V4) that is greater than the third voltage (V3), and
wherein the reference signal swings between the first voltage (V1) and the second voltage (V2) during the first cycle, and
wherein the valid signal swings (i) between the first voltage (V1) and the third voltage (V3) or (ii) between the first voltage (V1) and the fourth voltage (V4) in each of the remaining N cycles.

6. The memory device of claim 1, wherein each of the first current monitoring signal (CMS1) and the second current monitoring signal (CMS2) is a signal swinging between a first voltage (V1) and a second voltage (V2) that is greater than the first voltage (V1).

7. The memory device of claim 6, wherein the first current monitoring logic and the second current monitoring logic are configured to sequentially and repeatedly occupy the monitoring line (ML1, ML) for respective N cycles, and
each of the first current monitoring logic and the second current monitoring logic is configured to output:
a reference signal in a first cycle of the N cycles, and
a valid signal representing the N bits in remaining cycles of the N cycles.

8. The memory device of claim 7, wherein the reference signal is a return-to-zero, RZ, signal swinging between the first voltage (V1) and the second voltage (V2), and the valid signal is a multi-level signal swinging between the first voltage (V1) and the second voltage (V2).

9. The memory device of claim 6, wherein the first current monitoring logic and the second current monitoring logic are configured to sequentially and repeatedly occupy the monitoring line (ML1, ML) for respective N+1 cycles, and
wherein each of the first current monitoring logic and the second current monitoring logic is configured to output:
a reference signal in a first cycle of the N+1 cycles, and
a valid signal representing the N bits, each bit of the N bits being in a respective cycle of remaining N cycles of the N+1 cycles.

10. The memory device of claim 9, wherein each of the reference signal and the valid signal is an RZ signal swinging between the first voltage (V1) and the second voltage (V2).

11. The memory device of any one of claims 8 and 10, wherein the first current monitoring logic recovers the first clock signal by counting a predetermined time from a rising edge of the reference signal output by the second current monitoring logic.

12. The memory device of any one of claims 1 to 11, wherein the first memory die (11, 51, 210) is configured to, based on a last bit of the N bits of the first current data being output to the monitoring line (ML1, ML) and prior to a first bit of the N bits of the second current data being output to the monitoring line (ML1, ML), convert from a transmission mode to a reception mode, and
wherein the second memory die (12, 52, 220) is configured to, based on the last bit of the N bits of the first current data being output to the monitoring line (ML1, ML) and prior to the first bit of the N bits of the second current data being output to the monitoring line (ML1, ML), convert from the reception mode to the transmission mode.

13. The memory device of any one of claims 1 to 12, further comprising:
a package substrate (20) including a first surface on which the first memory die (11, 51, 210) and the second memory die (12, 52, 220) are mounted, and a second surface opposing the first surface and on which a plurality of solder balls (22) are disposed,
wherein the monitoring line (ML1, ML) is electrically isolated from the plurality of solder balls (22).

14. The memory device of any one of claims 1 to 13, wherein the first memory die (11, 51, 210) determines the peak value of the consumption current of the second memory die (12, 52, 220) based on the second current data, and
wherein the first memory die (11, 51, 210) stops a control operation when the peak value of the consumption current of the second memory die (12, 52, 220) is equal to or greater than a predetermined reference value.

15. The memory device of claim 14, wherein the first memory die (11, 51, 210) resumes the control operation, when a predetermined reference time period has elapsed after the control operation is stopped or when the peak value of the consumption current of the second memory die (12, 52, 220) decreases to be less than the reference value after the control operation is stopped.
